# EUROPÄISCHE PATENTSCHRIFT

(11) **EP 1 384 255 B1**
(45) Veröffentlichungstag und Bekanntmachung des Hinweises auf die Patenterteilung: **31.10.2007**
(21) Anmeldenummer: 02740548.9
(22) Anmeldetag: 30.04.2002
(51) Int. Cl.: H01L 21/302, H01L 21/78, H01L 21/68

(54) **VERFAHREN ZUM RÜCKSEITENSCHLEIFEN VON WAFERN**
METHOD FOR GRINDING THE BACK SIDES OF WAFERS
PROCEDE PERMETTANT DE POLIR LA FACE ARRIERE DE PLAQUETTES

(30) Priorität: 03.05.2001 DE 10121556
(43) Veröffentlichungstag der Anmeldung: 28.01.2004
(73) Patentinhaber: Infineon Technologies AG, 81669 München (DE)
(72) Erfinder: ROGALLI, Michael, 84056 Rottenburg (DE); SCHNEEGANS, Manfred, 85591 Vaterstetten (DE)
(74) Vertreter: Behnisch, Werner
(86) Internationale Anmeldenummer: PCT/EP2002/004776
(87) Internationale Veröffentlichungsnummer: WO 2002/091433

(56) Entgegenhaltungen:
- EP-A- 0 359 373
- EP-A- 1 002 845
- WO-A-92/15394
- WO-A-96/21704
- WO-A-98/49723
- WO-A-99/50902
- US-A- 5 366 573
- US-A- 5 639 811
- US-A- 6 048 749
- PATENT ABSTRACTS OF JAPAN vol. 1997, no. 08, 29. August 1997 (1997-08-29) -& JP 09 100450 A (LINTEC CORP), 15. April 1997 (1997-04-15) in der Anmeldung erwähnt
- PATENT ABSTRACTS OF JAPAN vol. 1999, no. 10, 31. August 1999 (1999-08-31) -& JP 11 140397 A (LINTEC CORP), 25. Mai 1999 (1999-05-25) in der Anmeldung erwähnt
- PATENT ABSTRACTS OF JAPAN vol. 2000, no. 11, 3. Januar 2001 (2001-01-03) -& JP 2000 223453 A (NITTO DENKO CORP), 11. August 2000 (2000-08-11) in der Anmeldung erwähnt

## Beschreibung

Die vorliegende Erfindung betrifft ein Verfahren zum Rückseitenschleifen von Wafern unter Verwendung von Folien, die eine an sich bekannte Trägerschicht und eine stufenweise polymerisierbare Haftschicht aufweisen.

### Hintergrund der Erfindung und Stand der Technik

Beim Rückseitenschleifen von Halbleiter-Wafern werden derzeit auf die Wafer-Vorderseite Schutzfolien geklebt, der so beschichtete Wafer wird mit der aufgebrachten Folie auf eine plane Unterlage gelegt, und es erfolgt ein Schleifen der Wafer-Rückseite, typischerweise mit einem Schleifmaterial aus Diamant. Die zum Rückseitenschleifen auf die Halbleiter-Wafer-Vorderseite geklebten Schutzfolien können derzeit nur Topographie-Unterschiede auf Wafer-Vorderseiten von maximal 150 µm ausgleichen und planarisieren. Neuartige Montageverfahren erfordern jedoch auf Scheibenvorderseiten zum Kontaktieren mit Leiterplatten, Platinen, Bords usw. in Zukunft Kontakt-Bumps mit einer Höhe von bis zu 250 µm und 300 - 500 µm im Durchmesser, anstelle der bisher üblichen Gold- oder Aluminium-Draht-Bondungen. Diese hohen Bumps können nicht mehr mit den derzeit verwendeten Schleiffolien planarisierend abgedeckt werden. Die herkömmlichen Folien können diese Topographie-Unterschiede nicht mehr ausgleichen, so daß ein nicht vollständiger Kontakt mit der Substratfläche gegeben ist und insbesondere die Folienrückseite, die beim Schleifen der Wafer-Rückseite auf der Unterlage aufliegt, nicht mehr planar ist, sondern Wellen aufweist. Der Schleifprozeß führt dann zu lokalen Dickenschwankungen (Dimpls) in den gedünnten Wafern, bis hin zum Bruch der Waferscheibe.

Die derzeit verwendeten Schleiffolien sind immer aus einem Trägermaterial (80 - 200 µm Schichtdicke) und einem Klebefilm bzw. Haftfilm mit einer Schichtdicke von 10 - 30 µm aufgebaut. Solche Folien sind beispielsweise von den Firmen Nitto, Adwill, Mitsui erhältlich und sind derzeit im Einsatz bei Wafer-Prozessen. Dabei ist der Klebefilm so polymerisiert, daß dieser visko-elastische Eigenschaften aufweist. Aufgrunddessen können Topographieunterschiede bis zu einem gewissen Maß eingeebnet werden, und das nach dem Schleifen notwendige Abziehen der Schutzfolie von der Halbleiterscheibe erfolgt weitgehend ohne auf der Substratoberfläche verbleibende Kleberreste. Voraussetzung hierfür ist jedoch, daß die Kontakt-Bumps auf Wafer-Vorderseiten nicht größer als 150 µm hoch sind. Bei größeren Kontakt-Bumps treten die oben genannten Nachteile auf. Zum Rückseitenschleifen von Wafern mit größeren Kontakt-Bumps stehen bisher keine einebnenden Schutzfolien bereit. Eine technische Lösung zum Rückseitenschleifen von Scheiben mit 200 µm hohen Bumps ist derzeit nicht bekannt.

Es ist weiterhin bekannt, Folien auf Wafer aufzubringen, die in der Haftschicht eine photopolymerisierbare Substanz aufweisen, wobei die Haftschicht visko-elastisch ist und durch die UV-Bestrahlung vollständig durchpolymerisiert wird. Solche Folien sind beispielsweise von den Firmen Nitto, Adwill, Mitsui erhältlich und sind derzeit im Einsatz bei Wafer-Prozessen. Dieses Verfahren ist ebenfalls nicht zum Rückseitenschleifen von Wafern geeignet, die auf ihrer Vorderseite Kontakt-Bumps oder andere Strukturen mit mehr als 150µm Höhe aufweisen, da auch hier die genannten Nachteile auftreten.

EP 926 732 beschreibt ein Verfahren zur Herstellung von Halbleitervorrichtungen, wobei ein drucksensitives Haftband auf einen Wafer aufgebracht wird, dieses erhitzt oder angedrückt wird und anschließend nach Rückseitenschleifen des Wafers eine photochemische Polymerisation erfolgt.

US 5,110,388 beschreibt ein Verfahren zur Befestigung von Chips mittels eines photopolymerisierbaren Haftbands.

JP 9100450 A (abstract) offenbart ein Klebeband mit einer Grundschicht und einer Haftschicht, welche eine strahlungshärtende Komponente und eine thermisch härtende Klebstoffkomponente aufweist. Die Klebebänder können zur Befestigung von Wafern verwendet werden, wenn aus diesen Chips gebildet werden.

JP 08054655 A offenbart ein Klebeband mit einer härtbaren drucksensitiven Haftschicht, enthaltend eine durch aktinische Strahlung härtende Komponente und eine thermisch härtende Komponente.

JP 11140397 A offenbart ein Haftband, das eine strahlungshärtende und eine wärmehärtende Komponente aufweist, sowie dessen Eignung zum Schutz vor Hitze und Feuchtigkeit.

In JP 2000223453 A ist ein strahlungshärtendes Schutzklebeband beschrieben, welches zwei verschiedene strahlungshärtende Komponenten aufweist.

EP 981 156 A2 beschreibt ein Verfahren zum Rückseitenschleifen von Wafern, bei dem auf die Wafervorderseite ein Haftschutzband aufgebracht wird, welches ein Elastizitätsmodul von mindestens 1.0 x 10⁵ Pa bei 40°C aufweist.

Es ist eine Aufgabe der vorliegenden Erfindung, ein Verfahren bereitzustellen, womit die genannten Nachteile beim Rückseitenschleifen von Halbleiter-Wafern nicht auftreten. Dies wird erfindungsgemäß durch ein Verfahren gemäß Anspruch 1 gelöst. Weitere und bevorzugte Ausführungsformen ergeben sich aus den Unteransprüchen und der nachfolgenden Beschreibung.

Gemäß Anspruch 1 wird ein Verfahren zum Rückseitenschleifen von Wafern bereitgestellt, mit den Schritten:
a) Aufbringen einer Folie, die eine Trägerschicht und eine Haftschicht aufweist, mit der Haftschichtseite auf die Wafer-Vorderseite, wobei das Aufbringen der Folie auf die Wafer-Vorderseite durch Laminieren erfolgt, wobei sich die Haftschicht den Halbleitertopographiestrukturen und/oder den Kontakt-Bumps auf der Waferoberfläche anpaßt, während die Trägerschicht rückseitig plan und parallel zur Waferoberfläche verläuft;
b) Durchführen einer ersten photochemisch initiierten Teilpolymerisation in der Haftschicht, wodurch die Haftschicht als Folge der ersten Teilpolymerisation ein elastisches Verhalten annimmt und die Haftung zwischen Haftschicht und Wafer-Oberfläche verstärkt wird;
c) Schleifen der Wafer-Rückseite,
d) Durchführen einer zweiten Teilpolymerisation in der Haftschicht, wodurch eine Verringerung der Haftung zwischen der Haftschicht und der Wafer-Oberfläche erreicht wird; und
e) Abziehen der Folie von der Wafer-Vorderseite.

### Beschreibung

Bei dem Verfahren gemäß der vorliegenden Erfindung zum Rückseitenschleifen von Wafern wird zunächst nach herkömmlichen Verfahren eine Folie auf die Wafer-Vorderseite aufgebracht, üblicherweise durch Laminieren, d.h. durch mechanisches Andrücken der Folie. Die Folie weist eine Trägerschicht und eine stufenweise polymerisierbare Haftschicht auf. Die stufenweise polymerisierbare Haftschicht ist so ausgelegt, dass zunächst eine photochemisch initiierte Teilpolymerisation und dann eine photochemisch oder thermisch initiierte Teilpolymerisation durchgeführt werden kann.

Die Folie kann üblicherweise in Rollen von 100 - 200 m Länge vorliegen und kann in für sämtliche Wafergrößen geeigneten Dimensionen angefertigt werden, bspw. in Breiten von 100 mm, 200 mm oder 300 mm.

Die Folie weist erfindungsgemäß eine an sich bekannte Trägerschicht mit einer Schichtdicke von vorzugsweise 80 - 200 µm auf. Als Träger werden bevorzugt thermoplastische Werkstoffe wie Polyethylen, und andere Polyolefine eingesetzt. Häufig wird auch PVC eingesetzt, dieses wird aber mehr und mehr vermieden, wegen der Gefahr von Cl-Kontamination.

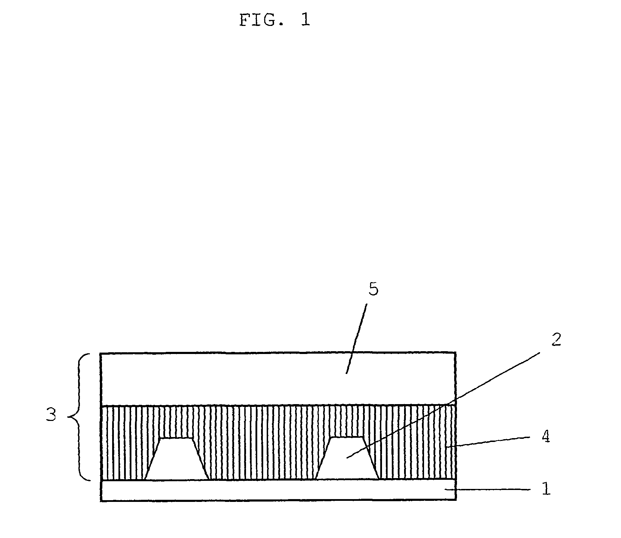

Als Haftschicht dient erfindungsgemäß eine stufenweise polymerisierbare Schicht von vorzugsweise bis zu 500µm, bevorzugt 150 - 300 µm Schichtdicke, noch bevorzugter 200 - 300µm Schichtdicke, mit zunächst viskos-plastischen Eigenschaften. Die Haftschichten weisen erfindungsgemäß bereits vorvernetzte Polymere, also Prepolymere auf. Die Molmassenverteilung ist dabei so gewählt, daß trotz Teilvernetzung eine viskose Benetzung möglich ist. Die Haftschicht weist dabei erfindungsgemäß eine Anfangshaftung (tacking) auf der Oberfläche auf. Beim Laminieren der Schutzfolie auf die Wafer-Vorderseite werden erfindungsgemäß die Kontakt-Bumps ohne Deformation oder Verspannungen in den weichen Klebefilm eingebettet, so daß die Folien-rückseitige Trägerschicht plan und parallel zur Wafer-Oberfläche verläuft. Dies ist in Fig. 1 schematisch dargestellt. Ein auf der Vorderseite mit Kontakt-Bumps (2) versehener Wafer (1) ist mit einer Folie (3) beschichtet, die eine Haftschicht (4) und eine Trägerschicht (5) aufweist. Die Rückseite der Trägerschicht verläuft plan und parallel zur Waferoberfläche bzw. zur Waferrückseite.

Nach dem Aufbringen der Folie auf die Wafer-Oberfläche, üblicherweise durch Laminieren, erfolgt eine erste photochemisch initiierte Teilpolymerisation der in der Haftschicht enthaltenen Prepolymere bzw. polymerisierbaren Substanzen, in der Regel durch UV-Bestrahlung. Die UV-Bestrahlung erfolgt bspw. mit üblichen UV-Lampen, die je nach verwendetem Photoinitiator ausgewählt werden. Über die Zeit oder Intensität der Bestrahlung kann der Polymerisationsgrad gesteuert werden. Hierdurch wird erfindungsgemäß der an die Wafer-Oberflächentopographie angepaßte Kleber teilausgehärtet und dieser erhält elastische Eigenschaften. Weiterhin wird die Haftung zwischen der Haftschicht und der Waferoberfläche hierdurch verstärkt. Anschließend erfolgt das Rückseitenschleifen des Wafers nach an sich bekannten Verfahren. Dabei wird der Wafer mit seiner Vorderseite auf eine zum Schleifen geeignete Unterlage gelegt, so dass die Waferrückseite zum Schleifen nach oben weist. Beim Rückseitenschleifen mit einer erfindungsgemäß aufgebrachten Folie können die auftretenden Schleifkräfte durch den hartelastischen Träger und die nach der ersten Teilpolymerisation elastischen und festeren Haftschicht weitgehend ohne Wafer-Deformation ausgeglichen werden. Die Folienrückseite liegt plan und parallel zur Waferrückseite auf der Unterlage auf, so daß beim Rückseitenschleifen weitgehend keine störenden Kräfte aufgrund von Unebenheiten in der Folienrückseite auftreten. Überdies ist die Wafer-Topographie bzw. die Wafer-Oberflächenstruktur vollständig in das elastische Haftschichtmaterial eingebettet, so daß eine optimale Dämpfung erreicht werden kann.

Das Rückseitenschleifen erfolgt erfindungsgemäß üblicherweise nach herkömmlichen Verfahren, weist also beispielsweise die Schritte auf:
Auflegen des Wafers mit der laminierten Seite auf einen Vakuumchuck, dieser Chuck rotiert und wird mit Wasser gespült. Aufsetzen eines rotierenden Diamantschleifringes auf die freie Rückseite des Wafers; Zustellen des Schleifringes bis zur gewünschten Tiefe, Abheben der Schleifscheibe, Wasserspülen, Abnehmen des Wafers, Weitertransport zur nächsten Schleifstation (Feinschliff), Zustellen der rotierenden Feinschleifscheibe auf die gewünschte Tiefe, Abheben der Schleifscheibe, Wasserspülen, Ausladen des dünnen Wafers.

An das Rückseitenschleifen schließt sich erfindungsgemäß eine zweite Teilpolymerisation von in der Haftschicht enthaltenen Polymeren bzw. polymerisierbaren Substanzen an. Hierdurch wird eine Umformung der in der Haftschicht enthaltenen Polymere insoweit bewirkt, als daß sich dadurch die Klebekräfte im Vergleich zu vor der ersten Teilpolymerisation verringern, bevorzugt auf 10 - 20%. Die zweite Teilpolymerisation bewirkt erfindungsgemäß insbesondere, daß an der Grenzfläche zwischen Substrat und aufgebrachter Haftschicht eine Verringerung der Wechselwirkung auftritt. Hierdurch kann das Abziehen der Schutzfolie ohne Schädigung der Bumps oder anderer Halbleitertopographien und weitgehend ohne verbleibende Kleberreste bzw. kontaminationsfrei auf der Wafer-Oberfläche erfolgen. "Weitgehend ohne verbleibende Kleberreste" bedeutet, daß nach Abziehen der Schutzfolie die verbleibende Oberfläche für die nachfolgenden Verwendungen ausreichend rein ist und/oder im Rasterelektronenmikroskop keine Kleberrückstände mehr sichtbar sind. Es ist bevorzugt, daß bei der zweiten Teilpolymerisation eine vollständige Umformung bzw. Polymerisation des noch nicht polymerisierten Anteils in der Haftschicht erfolgt.

Das Abziehen der Folie erfolgt üblicherweise durch Auflaminieren eines sehr stark klebenden Folienstreifens und mechanisches Abziehen des Streifens; dabei zieht der Folienstreifen das ganze Tape (Schutzfolie) von der Waferoberfläche. Der Wafer ist auf einem Vakuumchuck fixiert. Ein weiterer Reinigungsschritt erfolgt erfindungsgemäß bevorzugt nicht. Die erfindungsgemäßen Schutzfolien sind kleberrestefrei bzw. kontaminationsfrei abziehbar.

Das erfindungsgemäße Verfahren mit einer ersten photochemisch initiierten Teilpolymerisation hat den Vorteil, dass bei der photochemisch initiierten Teilpolymerisation der Polymerisationsprozess sehr gut steuerbar ist. Der Polymerisationsprozess kann daher leicht dann abgebrochen werden, wenn die Haftschicht elastisch geworden ist. Überraschend wurde festgestellt, dass hierbei nach Abziehen des Streifens im Anschluß an die zweite Polymerisation besonders kleberfreie Oberflächen erhalten werden und im wesentlichen keine mechanischen Beschädigungen oder Brüche des Wafers auftraten. Damit kann der Prozessablauf bei der Waferprozessierung deutlich verbessert werden.

Bei der erfindungsgemäßen Folie enthält die Trägerschicht Polymere, die auch in herkömmlichen Trägerschichten von Schleiffolien eingesetzt werden. Bevorzugt sind Polyethylene und andere Polyolefine. Die Schichtdicke der Trägerschicht beträgt erfindungsgemäß bevorzugt 80 - 200 µm.

An die Haftschicht ist die Anforderung zu stellen, daß eine selektive Vernetzung bzw. stufenweise Vernetzung/Polymerisation der darin enthaltenen Prepolymere bzw. polymerisierbaren Substanzen möglich ist. Dies wird erfindungsgemäß durch chemische Hybridsysteme gewährleistet. Grundsätzlich können erfindungsgemäß zwei Formen solcher Hybridsysteme unterschieden werden, nämlich Hybridsysteme erster Ordnung und Hybridsysteme zweiter Ordnung.

Charakteristisch für Hybridsysteme erster Ordnung ist erfindungsgemäß, daß eine selektive thermische oder photochemische Vernetzbarkeit gewährleistet ist. Es kann erfindungsgemäß zunächst eine photochemische und dann eine thermische Polymerisation erfolgen. Die Verfahrensführung kann somit der entsprechenden Prozeßfolge in der Montage angepaßt werden.

Eine stufenweise Polymerisation ist im Fall der Hybridsysteme erster Ordnung zum einen möglich, wenn die Haftschicht aus einem Prepolymergemisch bzw. einem Gemisch polymerisierbarer Substanzen zusammengesetzt ist, welches neben einem thermisch polymerisierbaren Anteil einen weiteren photochemisch polymerisierbaren Anteil enthält.

Es ist erfindungsgemäß aber auch möglich, daß in der Haftschicht nur eine Sorte polymerisierbarer Substanz bzw. Prepolymer enthalten ist, die durch Kombination aus thermisch und photochemisch aktivierbaren Initiatoren selektiv und stufenweise polymerisierbar ist. Dies geschieht bspw. über verschiedene funktionelle Gruppen die teils durch thermische teils durch photochemische Initiatoren zur Reaktion gebracht werden.

Als Prepolymerbestandteile von Hybridsystemen erster Ordnung kommen erfindungsgemäß Acrylate, Polyurethane, Epoxide, Polyester und/oder Polyether sowie Derivate und gemische hiervon in Frage. Bevorzugt sind beispielsweise Acrylate, bevorzugt multifunktionelle Acrylate, in Kombination mit funktionellen Prepolymeren.

Als verwendbare funktionelle Prepolymere stehen bevorzugt eine Vielzahl von kommerziell erhältlichen Produkten mit unterschiedlichen Backbones wie Acrylate, Polyurethane, Epoxide, Polyester und/oder Polyether oder Derivate hiervon zur Verfügung. Die Acrylate und anderen Prepolymere weisen bevorzugt als funktionelle Gruppen, die über Initiatoren zur Reaktion gebracht werden können, Doppelbindungen auf.
Die chemischen Hybridsysteme erster Ordnung weisen als unterschiedliche Initiatoren als thermische Initiatoren vorzugsweise Peroxide, bevorzugt Benzoylperoxid oder Di-tert.-butylperoxid und als photochemische UV-Starter bevorzugt aromatische Carbonylverbindungen, die einer Norrish Typ 1 Fragmentierung unterliegen, wie bspw. Benzoin, Benzoinderivate, Benzilketale und/oder Acetophenonderivate auf. Ebenfalls bevorzugt sind Acylphosphinoxide oder alpha-Aminoketone.

Eine erfindungsgemäß besonders bevorzugte Haftschichtzusammensetzung ist ein linearer Polyester mit einem Triacrylat, bevorzugt Trimethylolpropantriacrylat (TMPTA) als multifunktionellem Acrylat als Vernetzungsbestandteil in Verbindung mit Benzoin und Benzoylperoxid. Hiermit wurden in Tests besonders gute Ergebnisse erzielt.

Die Menge des Photoinitiators variiert erfindungsgemäß bevorzugt von 0,3 Gew.-% bis 5 Gew.-%, noch bevorzugter 0,3 bis 3 Gew.-%, weiterhin bevorzugt ungefähr 2 Gew.-%, die Menge des thermischen Starters bevorzugt von 0,5 Gew.-% bis 1,5 Gew.-%, weiterhin bevorzugt ungefähr 1 Gew.-%.

Mengenmäßig können die Haftschichtbestandteile in weiten Grenzen variieren, es werden aber erfindungsgemäß bevorzugt übliche Mengen an Bestandteilen, also Prepolymeren und Initiatoren eingesetzt. Die Anteile multifunktioneller Acrylate und Polyester sind beliebig variierbar. Bevorzugt beträgt das Verhältnis Polyester zu Acrylat in Gew.-% ungefähr 70 -90 zu 10 bis 30, bevorzugt ungefähr 80 zu 20.

Erfindungsgemäß läßt sich durch den ersten Vernetzungsschritt die gewünschte Steifigkeit, Festigkeit und Elastizität der Haftschicht für das Dünnschleifen einstellen. Der zweite Teilpolymerisationsschritt bewirkt die notwendige Reduktion der Klebekraft. Diese Abfolge ist mit beliebigen thermisch und photochemisch vernetzbaren Mischformulierungen durchführbar, sofern sie den Anforderungen der Vormontage entsprechen. Bevorzugt sind diese Mischformulierungen transparent.

Bei Hybridsystemen zweiter Ordnung sind die in der Haftschicht enthaltenen Prepolymere bzw. polymerisierbaren Substanzen ausschließlich photochemisch vernetzbar. Erste und zweite Teilpolymerisation erfolgen also photochemisch. Die Vernetzung erfolgt mehrstufig bevorzugt dadurch, daß die Filme verschiedene Photoinitiatoren enthalten. Die unterschiedlichen Selektivitäten der Photoinitiatoren beruhen auf deren unterschiedlichen Wellenlängen-spezifischen Empfindlichkeiten. Je nach eingestrahlter Wellenlänge erfolgt die Aktivierung des betreffenden Initiators und bewirkt somit die gewünschten Teilvernetzungen. Nach dem Aufbringen des viskosen Klebefilms werden Topographien auf der Wafer-Oberfläche ausgeglichen, die erste Belichtung vernetzt und festigt den Klebefilm, die zweite Belichtung nach dem Dünnschleifen löst die Klebehaftung zwischen Folie und Wafer-Oberfläche. Die Auswahl der Photoinitiatoren kann an die Equipment-Anfertigungsgegebenheiten angepaßt werden.

Erfindungsgemäß ist als Hybridsystem zweiter Ordnung bevorzugt ein System umfaßt, bei dem nur ein Prepolymer bzw. polymerisierbare Substanz vorliegt, das durch einen ersten Initiator polymerisierbar ist, wobei die Polymerisation durch die Verfahrensparameter gestoppt werden oder durch die mengenmäßigen Anteile der Initiatoren gesteuert werden kann, und anschließend ein zweiter Initiator aktiviert wird, um die zweite Teilpolymerisation zu starten.

Erfindungsgemäß können die Hybridsysteme zweiter Ordnung bevorzugt auch ein Gemisch von Polymeren bzw. polymerisierbaren Substanzen sein, wobei eine erste polymerisierbare Substanz/Polymer durch einen ersten Photoinitiator und eine zweite polymerisierbare Substanz/Polymer durch einen zweiten Photoinitiator polymerisierbar ist.

Als Polymere bei den Hybridsystemen zweiter Ordnung können erfindungsgemäß dieselben Polymere eingesetzt werden, wie die oben bei den Hybridsystemen erster Ordnung aufgeführten Polymere. Voraussetzung ist selbstverständlich, daß diese einer Initiierung durch photochemische Initiatoren zugänglich sind.

Erfindungsgemäß ist grundsätzlich zu gewährleisten, daß die erste Polymerisation noch nicht vollständig ist. Dies kann durch die Polymerisationsparameter, beispielsweise bei der thermischen Polymerisation durch die Dauer der Behandlung oder die eingesetzte Temperatur oder bei der photochemischen Polymerisation durch die Menge an Initiator und/oder Dauer der UV-Bestrahlung erfolgen. Weiterhin ist erfindungsgemäß eine Steuerung im Fall eines Gemischs von polymerisierbaren Substanzen oder Polymeren über die mengenmäßigen Anteile der photochemisch oder thermisch polymerisierbaren Substanzen oder Polymere sowie der beteiligten Initiatoren möglich.

Erfindungsgemäß können die Haftschichdicken bevorzugt bis zu 500µm betragen. Die Haftschichten weisen erfindungsgemäß bevorzugt eine Dicke von 150 - 300 µm, weiterhin bevorzugt 200 - 300 µm, auf. Es sind erfindungsgemäß aber auch Dicken außerhalb dieser Grenzen umfaßt. Die Schichtdicken könne erfindungsgemäß an das beim Schleifen zu schützende Substrat angepaßt werden. Geeignete Anteile können vom Fachmann bestimmt werden.

Die Wafer als Substrate bestehen aus Silicium, und können darauf befindliche Halbleiterstrukturen, z.B. integrierte Speicher-, Logik-, Power- oder auch Einzelhalbleiter-Schaltungen, sowie insbesondere Kontakt-Bumps aufweisen. Diese Kontakt-Bumps sind üblicherweise Polymere, auf denen sich erfindungsgemäß auch darauf führende Metallbahnen befinden können. Die zu beschichtenden Wafer-Vorderseiten bilden somit für die Haftschicht der Folie eine Oberfläche aus Silicium, Leitermetallen und/oder isolierenden bzw. elektrischen Polymeren. Die Kontakt-Bumps auf der Wafer-Vorderseite können erfindungsgemäß bevorzugt eine Höhe von 150 - 250 µm und einen Durchmesser von 300 - 500µm aufweisen.

Die erfindungsgemäßen Folien können bevorzugt in Rollenform gelagert werden, bevorzugt mit einer Länge von 100 bis 200m. Die Breite der Folien kann an den Durchmesser des zu beschichtenden Wafer-Substrats angepaßt werden.

Die vorliegende Erfindung umfaßt weiterhin Wafer, die mit den erfindungsgemäßen Folien beschichtet sind. Außerdem sind erfindungsgemäß Wafer umfaßt, die unter Einsatz des erfindungsgemäßen Verfahren hergestellt wurden.

Die Erfindung wird im folgenden anhand von Ausführungsbeispielen erläutert, die den Umfang der Erfindung jedoch nicht einschränken sollen.

In der Beschreibung und der Erfindung wird auf die folgenden Figuren Bezug genommen:
Figur 1 zeigt einen erfindungssgemäß beschichteten Wafer mit darauf befindlichen Kontakt-Bumps.

### Beispiele

### 1. Folie mit Hybridsystem erster Ordnung

Auf Wafer mit 200 oder 300 mm Durchmesser und darauf befindlichen integrierten Schaltungen, sowie Kontakt-Bumps mit 250 µm Höhe (Polymer- oder Metall-Bumps) und einem Durchmesser von 400 µm wurden mittels einer Anpressrolle jeweils Folien laminiert. Die Folien wiesen eine 150 µm dicke Trägerschicht aus Polyolefinen oder PVC auf. Die Haftschicht der Folie wies folgende Zusammensetzung auf: 77,5 Gew.-% linearer Polyester und 19,5 Gew.% eines Triacrylats (TMPTA) als Vernetzungsbestandteil in Verbindung mit 2 Gew.-% Benzoin und 1 Gew.-% Benzoylperoxid. Die Schichtdicke der Haftschicht betrug 300 µm.

Es folgte eine erste photochemisch initiierte Teilpolymerisation, die so über die Strahlungsintensität oder Zeit gesteuert wurde, dass die Haftschicht ein elastisches Verhalten annahm.

Anschließend wurde die Trägerrückseite auf einen rotierenden Vakuumchuck, der Bestandteil der Schleifmaschine ist, als Unterlage positioniert, und es erfolgte ein Schleifen der Wafer-Rückseite. Beim Schleifen wurden folgende Schritte durchgeführt: Auflegen des Wafers mit der laminierten Seite auf einen Vakuumchuck, dieser Chuck rotiert und wird mit Wasser gespült. Aufsetzen eines rotierenden Diamantschleifringes auf die freie Rückseite des Wafers; Zustellen des Schleifringes bis zur gewünschten Tiefe, Abheben der Schleifscheibe, Wasserspülen, Abnehmen des Wafers, Weitertransport zur nächsten Schleifstation (Feinschliff), Zustellen der rotierenden Feinschleifscheibe auf gewünschte Tiefe, Abheben der Schleifscheibe, Wasserspülen, Ausladen des dünnen Wafers.

Nach dem Rückseitenschleifen wird eine zweite thermisch initiierte Teilpolymerisation durch Temperaturerhöhung durchgeführt, so dass eine weitgehend vollständige Durchpolymerisation erreicht wurde. Hiernach wird die Folie von dem Wafer-Substrat abgezogen. Es erfolgte kein weiterer Reinigungsschritt.

Im Rasterelektronenmikroskop konnten keine Kleberrückstände auf dem Wafer-Substrat festgestellt werden. Bei wiederholten Versuchen wurden keine mechanischen Beschädigungen oder Brüche eines Wafers beobachtet.

## Patentansprüche

1. Verfahren zum Rückseitenschleifen von Wafern, mit den Schritten:
a) Aufbringen einer Folie, die eine Trägerschicht und eine Haftschicht aufweist, mit der Haftschichtseite auf die Wafer-Vorderseite, wobei das Aufbringen der Folie auf die Wafer-Vorderseite durch Laminieren erfolgt, wobei sich die Haftschicht auf der Waferoberfläche befindlichen Halbleitertopographiestrukturen und/oder Kontakt-Bumps anpaßt, während die Trägerschicht rückseitig plan und parallel zur Waferoberfläche verläuft;
b) Durchführen einer ersten photochemisch initiierten Teilpolymerisation in der Haftschicht, wodurch die Haftschicht als Folge der ersten Teilpolymerisation ein elastisches Verhalten annimmt und die Haftung zwischen Haftschicht und Wafer-Oberfläche verstärkt wird;
c) Schleifen der Wafer-Rückseite,
d) Durchführen einer zweiten Teilpolymerisation in der Haftschicht, wodurch eine Verringerung der Haftung zwischen der Haftschicht und der Wafer-Oberfläche erreicht wird; und
e) Abziehen der Folie von der Wafer-Vorderseite..

2. Verfahren nach Anspruch 1,
**dadurch gekennzeichnet,**
**daß** die Wafer-Vorderseite mit Halbleiterstrukturen versehen ist.

3. Verfahren nach Anspruch 1 oder 2,
**dadurch gekennzeichnet,**
**daß** die Wafer-Vorderseite Kontakt-Bumps in einer Höhe von 150 - 250 µm und mit einem Durchmesser von 300 - 500 µm aufweist.

4. Verfahren nach einem oder mehreren der vorhergehenden Ansprüche,
**dadurch gekennzeichnet,**
**daß** die zweite Teilpolymerisation thermisch oder photochemisch initiiert wird.

5. Verfahren nach einem oder mehreren der vorhergehenden Ansprüche,
**dadurch gekennzeichnet,**
**daß** die Trägerschicht beim Rückseitenschleifen des Wafers plan auf einer Unterlage aufliegt.

6. Verfahren nach einem der vorhergehenden Ansprüche, **dadurch gekennzeichnet,**
**daß** die Trägerschicht an sich bekannte Prepolymere aufweist, bevorzugt Polyolefine.

7. Verfahren nach einem der vorhergehenden Ansprüche,
**dadurch gekennzeichnet,**
**daß** die Dicke der Trägerschicht 80 - 200 µm beträgt.

8. Verfahren nach einem der vorhergehenden Ansprüche,
**dadurch gekennzeichnet,**
**daß** die Haftschicht ein thermisch polymerisierbares und ein photochemisch polymerisierbares Prepolymer aufweist.

9. Verfahren nach einem der Ansprüche 1-7,
**dadurch gekennzeichnet,**
**daß** die Haftschicht zwei photochemisch polymerisierbare Prepolymere aufweist.

10. Verfahren nach einem der Ansprüche 1-7,
**dadurch gekennzeichnet,**
**daß** die Haftschicht ein Prepolymer aüfweist, das durch eine Kombination aus einem thermisch aktivierbaren und einem photochemisch aktivierbaren Initiator selektiv polymerisierbar ist.

11. Verfahren nach einem der Ansprüche 1-7,
**dadurch gekennzeichnet,**
**daß** die Haftschicht ein Prepolymer aufweist, das durch eine Kombination aus zwei verschiedenen photochemisch aktivierbaren Initiatoren selektiv polymerisierbar ist.

12. Verfahren nach einem oder mehreren der Ansprüche 1-7,
**dadurch gekennzeichnet,**
**daß** die Haftschicht als thermisch und/oder photochemisch polymerisierbare Prepolymere Acrylate, Polyurethane, Epoxide, Polyester, Polyether und/oder Derivate oder Gemische hiervon aufweist.

13. Verfahren nach einem der vorhergehenden Ansprüche 1-9 oder 12,
**dadurch gekennzeichnet,**
**daß** die Haftschicht als thermisch und/oder photochemisch polymerisierbare Prepolymere multifunktionelle Acrylate in Kombination mit funktionellen Prepolymeren aufweist, wobei als funktionelle Prepolymere Polymere mit unterschiedlichen Backbones wie Polyurethane, Epoxide, Polyester und/oder Polyether oder Derivate hiervon enthalten sind und die Acrylate Doppelbindungen aufweisen.

14. Verfahren nach einem der vorhergehenden Ansprüche 1-8, 10, 12, oder 13,
**dadurch gekennzeichnet,**
**daß** die Haftschicht als thermische(n) Initiator(en) Peroxide, bevorzugt Benzoylperoxid und/oder Di-tert.-butylperoxid, enthält.

15. Verfahren nach einem der vorhergehenden Ansprüche,
**dadurch gekennzeichnet,**
**daß** die Haftschicht als photochemische(n) Initiator (en) aromatische Carbonylverbindungen, die einer Norrish Typ 1 Umlagerung unterliegen, bevorzugt Benzoin, Benzoinderivate, Benzilketale, Acetophenonderivate und/oder Acylphosphinoxide oder alpha-Aminoketone, aufweist.

16. Verfahren nach einem der vorhergehenden Ansprüche 1-7, 9, 11-13 oder 15,
**dadurch gekennzeichnet,**
**daß** die Photoinitiatoren bei unterschiedlichen Wellenlängen aktivierbar sind.

17. Verfahren nach einem der vorhergehenden Ansprüche,
**dadurch gekennzeichnet,**
**daß** die Haftschicht eine Dicke von bis zu 500 µm, bevorzugt 150 - 300 µm, noch bevorzugter 200 - 300 µm, aufweist.

## Claims

1. Process for back-surface grinding of wafers, comprising the following steps:
a) applying a film, which has a support layer and an adhesion layer, by means of the adhesion-layer side, to the wafer front surface, the film being applied to the wafer front surface by lamination, the adhesion layer matching semiconductor topography structures and/or contact bumps situated on the wafer surface, while the support layer, on the rear side, runs plane-parallel to the wafer surface;
b) carrying out a first photochemically initiated partial polymerization in the adhesion layer, with the result that the adhesion layer adopts an elastic behavior as a result of the first partial polymerization and the adhesion between adhesion layer and wafer surface is reinforced;
c) grinding the wafer back surface,
d) carrying out a second partial polymerization in the adhesion layer, with the result that the adhesion between the adhesion layer and the wafer surface is reduced; and
e) pulling the film off the wafer front surface.

2. Process according to Claim 1, **characterized in that** the wafer front surface is provided with semi-conductor structures.

3. Process according to Claim 1 or 2, **characterized in that** the wafer front surface has contact bumps of a height of 150 - 250 µm and a diameter of 300 - 500 µm.

4. Process according to one or more of the preceding claims, **characterized in that** the second partial polymerization is thermally or photochemically initiated.

5. Process according to one or more of the preceding claims, **characterized in that** the support layer rests flat on a base during the back-surface grinding of the wafer.

6. Process according to one of the preceding claims, **characterized in that** the support layer includes prepolymers which are known per se, preferably polyolefins.

7. Process according to one of the preceding claims, **characterized in that** the thickness of the support layer is 80 - 200 µm.

8. Process according to one of the preceding claims, **characterized in that** the adhesion layer includes a thermally polymerizable prepolymer and a photochemically polymerizable prepolymer.

9. Process according to one of Claims 1 - 7, **characterized in that** the adhesion layer includes two photochemically polymerizable prepolymers.

10. Process according to one of Claims 1 - 7, **characterized in that** the adhesion layer includes a prepolymer which can be selectively polymerized by a combination of a thermally activatable initiator and a photochemically activatable initiator.

11. Process according to one of Claims 1 - 7, **characterized in that** the adhesion layer includes a prepolymer which can be selectively polymerized by a combination of two different photochemically activatable initiators.

12. Process according to one or more of Claims 1 - 7, **characterized in that** the adhesion layer includes acrylates, polyurethanes, expoxides, polyesters, polyethers and/or derivatives or mixtures thereof as thermally and/or photochemically polymerizable prepolymers.

13. Process according to one of the preceding Claims 1 - 9 or 12, **characterized in that** the adhesion layer includes multifunctional acrylates in combination with functional prepolymers as thermally and/or photo-chemically polymerizable prepolymers, polymers with different backbones, such as polyurethanes, epoxides, polyesters and/or polyethers or derivatives thereof being present as functional prepolymers and the acrylates having double bonds.

14. Process according to one of the preceding Claims 1 - 8, 10, 12 or 13, **characterized in that** the adhesion layer contains peroxides, preferably benzoyl peroxide and/or di-tertbutyl peroxide, as thermal initiator(s).

15. Process according to one of the preceding claims, **characterized in that** the adhesion layer includes aromatic carbonyl compounds, which undergo a Norrish type 1 rearrangement, preferably benzoin, benzoin derivatives, benzil ketals, acetophenone derivatives and/or acylphosphine oxides or alpha-amino ketones, as photochemical initiator(s).

16. Process according to one of the preceding Claims 1 - 7, 9, 11 - 13 or 15 **characterized in that** the photoinitiators can be activated at different wavelengths.

17. Process according to one of the preceding claims, **characterized in that** the adhesion layer has a thickness of up to 500 µm, preferably 150 - 300 µm, more preferably 200 - 300 µm.

## Revendications

1. Procédé de polissage de faces arrière de tranches de silicium, avec les étapes consistant à :
a) appliquer un film, comportant une couche de support et une couche d'adhérence, avec la face de la couche d'adhérence sur la face avant de la tranche de silicium, l'application du film sur la face avant de la tranche de silicium étant effectuée par laminage, la couche d'adhérence s'adaptant à la topographie des structures semi-conductrices et/ou de plots de contact se trouvant sur la surface de la tranche de silicium, alors que sur la face arrière, la couche de support s'étend de façon plane et parallèle à la surface de la tranche de silicium ;
b) réaliser une première polymérisation partielle initiée par voie photochimique dans la couche d'adhérence, ce qui, comme conséquence de la première polymérisation partielle, confère à la couche d'adhérence un comportement élastique, et renforce l'adhérence entre la couche d'adhérence et la surface de la tranche de silicium ;
c) polir la face arrière de la tranche de silicium ;
d) réaliser une deuxième polymérisation partielle dans la couche d'adhérence, ce qui conduit à une réduction de l'adhérence entre la couche d'adhérence et la surface de la tranche de silicium ; et
e) retirer le film de la face avant de la tranche de silicium.

2. Procédé selon la revendication 1,
**caractérisé en ce que** la face avant de la tranche de silicium est pourvue de structures semi-conductrices.

3. Procédé selon la revendication 1 ou 2,
**caractérisé en ce que** la face avant de la tranche de silicium comporte des plots de contact d'une hauteur de 150 à 250 µm, et d'un diamètre de 300 à 500 µm.

4. Procédé selon l'une ou plusieurs des revendications précédentes,
**caractérisé en ce que** la deuxième polymérisation partielle est initiée par voie thermique ou photochimique.

5. Procédé selon l'une ou plusieurs des revendications précédentes,
**caractérisé en ce que**, lors du polissage de la face arrière de la tranche de silicium, la couche de support est positionnée de façon plane sur une base.

6. Procédé selon l'une des revendications précédentes,
**caractérisé en ce que** la couche de support contient des pré-polymères connus en soi, de préférence des polyoléfines.

7. Procédé selon l'une des revendications précédentes,
**caractérisé en ce que** l'épaisseur de la couche de support est de 80 à 200 µm.

8. Procédé selon l'une des revendications précédentes,
**caractérisé en ce que** la couche d'adhérence contient un pré-polymère polymérisable par voie thermique et un pré-polymère polymérisable par voie photochimique.

9. Procédé selon l'une des revendications 1 à 7,
**caractérisé en ce que** la couche d'adhérence contient deux pré-polymères polymérisables par voie photochimique.

10. Procédé selon l'une des revendications 1 à 7,
**caractérisé en ce que** la couche d'adhérence contient un pré-polymère, qui peut être polymérisé sélectivement par une combinaison constituée d'un initiateur susceptible d'être activé par voie thermique et d'un initiateur susceptible d'être activé par voie photochimique.

11. Procédé selon l'une des revendications 1 à 7,
**caractérisé en ce que** la couche d'adhérence contient un pré-polymère, qui peut être polymérisé sélectivement par une combinaison constituée de deux différents initiateurs susceptibles d'être activés par voie photochimique.

12. Procédé selon l'une ou plusieurs des revendications 1 à 7,
**caractérisé en ce que**, en tant que pré-polymères polymérisables par voie thermique et/ou photochimique, la couche d'adhérence contient des acrylates, des polyuréthanes, des époxydes, des polyesters, des polyéthers et/ou des dérivés ou mélanges de ceux-ci.

13. Procédé selon l'une des revendications précédentes 1 à 9 ou 12,
**caractérisé en ce que**, en tant que pré-polymères polymérisables par voie thermique et/ou photochimique, la couche d'adhérence présente des acrylates multifonctionnels en combinaison avec des pré-polymères fonctionnels, des polymères à différents squelettes tels que des polyuréthanes, des époxydes, des polyesters et/ou des polyéthers ou des dérivés de ceux-ci, et qui présentent des doubles liaisons acrylates, étant contenus en tant que pré-polymères fonctionnels.

14. Procédé selon l'une des revendications précédentes 1 à 8, 10, 12 ou 13,
**caractérisé en ce que**, en tant qu'initiateur(s) thermique(s), la couche d'adhérence contient des peroxydes, de préférence du peroxyde de benzoyle et/ou du Di-tert.-butylperoxyde.

15. Procédé selon l'une des revendications précédentes,
**caractérisé en ce que** en tant qu'initiateur(s) photochimique(s), la couche d'adhérence contient des composés carbonyles aromatiques, qui sont soumis à une transposition de Norrish de type 1, de préférence de la benzoïne, des dérivés de benzoïne, des benzylcétals, des dérivés d'acétophénone et/ou des oxydes d'acylphosphine ou des alpha-aminocétones.

16. Procédé selon l'une des revendications précédentes 1 à 7, 9, 11 à 13 ou 15,
**caractérisé en ce que** les photo-initiateurs peuvent être activés à différentes longueurs d'ondes.

17. Procédé selon l'une des revendications précédentes,
**caractérisé en ce que** la couche d'adhérence a une épaisseur jusqu'à 500 µm, de préférence de 150 à 300 µm, de façon encore plus préférée de 200 à 300 µm.
